Europäisches Patentamt

European Patent Office

Office européen des brevets

(19)

(11) Veröffentlichungsnummer: **0 180 107**
**B1**

(12) **EUROPÄISCHE PATENTSCHRIFT**

(45) Veröffentlichungstag der Patentschrift: **27.12.90**

(51) Int. Cl.⁵: **B 26 F 3/12**

(21) Anmeldenummer: **85113220.9**

(22) Anmeldetag: **18.10.85**

(54) Schneidvorrichtung mit einem beheizten Schneiddraht.

(30) Priorität: **27.10.84 DE 3439455**

(43) Veröffentlichungstag der Anmeldung:
**07.05.86 Patentblatt 86/19**

(45) Bekanntmachung des Hinweises auf die
Patenterteilung:
**27.12.90 Patentblatt 90/52**

(84) Benannte Vertragsstaaten:
**AT BE CH DE FR GB IT LI NL SE**

(56) Entgegenhaltungen:
**EP-A-0 163 315**
**BE-A- 878 626**
**DE-A-3 046 643**
**US-A-4 017 012**
**US-A-4 044 639**
**US-A-4 365 152**

(73) Patentinhaber: **HOECHST
AKTIENGESELLSCHAFT
Postfach 80 03 20
D-6230 Frankfurt am Main 80 (DE)**

(72) Erfinder: **Kühnert, Hans-Günter Egbert
Lerchenweg 8
D-6106 Erzhausen (DE)**

Courier Press, Leamington Spa, England.

# Beschreibung

Die Erfindung betrifft eine Schneidvorrichtung mit einem beheizten Schneiddraht, dessen Halterung auf einem Schlitten montiert ist, der pneumatisch angetrieben ist, wobei die Halterung in eine zur Schlittenbewegung senk rechten Richtung bewegbar ist.

Eine derartige Schneidvorrichtung ist aus der BE-A-878 626 bekannt. Für die Bewegung der Halterung des Schneiddrahtes und des Schlittens können bei dieser bekannten Schneidvorrichtung mechanische, pneumatische oder elektrische Antriebe vorgesehen werden.

Vor dem Laminieren von Schichtträgern wie Leiterplaten, Multilayerschichten, Metallplatten oder Substraten mit beidseitig aufgedampften und/oder aufgeklebten Metallschichten, mit einem Fotoresistfilm, wird dieser faltenfrei auf horizontal oder vertikal ausgerichteten Saugplatten von Vakuumtischen aufgespannt und auf das gewünschte Format geschnitten, das für ein dekkungsgleiches Auflaminieren des Fotoresistfilms auf den jeweiligen Schichtträger erforderlich ist.

Aus den offengelegten europäischen Patentanmeldungen 0 040 842, 0 040 843 und 0 041 642 sind Laminiervorrichtungen bekannt, bei denen ein Substrat bzw. ein Schichtträger beidseitig unter Druckanwendung mit einem Trockenresist laminiert wird. Der Trockenresist wird für die jeweilig zu laninierende Seite des Schichtträgers, beispielsweise eine Leiterplatte, von einer Vorratsrolleabgezogen und einem paar von Laminierwalzen zugeführt, durch deren Spalt die beiden Trockenresistfilme und der dazwischen befindliche Schichtträger hindurchlaufen.

Aus der DE-A-3046 643 ist eine Schneidvorrichtung für Platten aus Hartschaumstoff bekannt, die eine parallele Führungseinrichtung für einen beheizten Schneiddraht aufweist, der parallel zu einer Grundplatte ausgerichtet ist, auf der die zu schneidenden Platten aufliegen, und darüber hinaus senkrecht zur Platte beweglich ist. Der beheizte Schneiddraht wird von Rollen gehalten und ist mit einer Spanneinrichtung ausgerüstet. Rechtwinklig zur Grundplatte sind Führungsschienen ausgerichtet, die einen Schlitten führen, an dem der Schneiddraht befestigt ist. In der Grundplatte ist eine Ausnehmung vorhanden, in die der Schneiddraht eintaucht.

In der Patentschrift US-A-4 017 012 ist eine Schneidvorrichtung mit beheizten Schneidklingen zum Durchschneiden von Kunststoffbahnen oder Kunststoffblättern beschrieben. Die obere Schneidklingenanordnung wird mittels Hydraulikmotoren entlang von vertikalen Führungsstangen, die als Zahnstangen ausgebildet sind, verfahren. Die obere Schneidklinge bewegt sich in der gleichen Vertikalebene wie die untere Schneidklinge, und es sind Einrichtungen zum Anhalten der Abwärtsbewegung der oberen Schneidklinge vorhanden, wenn diese sich der unteren Schneidlinge nähert, bevor es zu dem Eingriff mit der. unteren Schneidklinge kommt.

In der Europäischen Patentanmeldung EP-A- 0 163 315 wird eine Schneideinrichtung zum Durchschneiden von Trockenresistfilmen vorgeschlagen, die ein Rotationsmesser umfaßt, das höhenverstellbar ist und über vertikal angeordnete Vakuumtische verfahren werden kann. Sobald das Rotationsmesser seine vorgegebene Höhe erreicht hat, wird es quer über den Vakuumtisch verfahren, um den auf der Saugplatte des Vakuumtisches aufgespannten Trockenresistfilm zu durchschneiden. Das Rotationsmesser ist auf einem Messerträger angeordnet, der schwenkbar an Führungen gelagert ist, die entlang den vertikalen Führungsstangen zu beiden Seiten der Vakuumtische verschiebbar sind. Ein Querträger verbindet die beiden Führungen und ist mit Streben ausgerüstet, an denen eine quer zu dem Fotoresistfilm verlaufende Schiene mit Schneidkante befestigt ist. Der Querträger kann mit Hilfe eines Klemmstückes in der gewünschten Position auf den Führungsstangen festgeklemmt werden. Mit der Zahnstange steht ein Getriebe fürden Messerantrieb im Eingriff, das von einem Motor angetrieben und über die Breite des Fotoresistfilms verfahren wird. Das Getriebe setzt das Rotationsmesser in Drehung und bewegt es entlang der Schneidkante der Schiene über den Fotoresistfilm während des Schneidvorgangs. Das Schneiden erfolgt mechanisch, so daß das Rotationsmesser stets scharf geschliffen sein muß, um ein Absplittern des Fotoresistfilms entlang der Schnittkante, verursacht durch ein stumpfes Rotationsmesser, zu vermeiden. Die Bewegung des Rotationsmessers quer über den Fotoresist während des Schneidens ist relativ langsam im Vergleich zu der in dieser deutschen Patentanmeldung gleichfalls vorgeschlagenen Schneidvorrichtung, die mit einem beheizten Schneiddraht anstelle eines Rotationsmessers arbeitet. Diese Schneideinrichtung ist um eine Schwenkachse, die ein Motor betätigt, schwenkbar. Die Schwenkachse ist in Führungen gelagert, die durch eine Positioniervorrichtung entlang von Führungsstangen in einer vorwählbaren Stellung festlegbar sind. Auf der Schwenkachse sitzen zwei Lagerblöcke auf, in denen je ein Lagerarm gelagert ist, die an ihren anderen Enden mit einem Träger für den Schneiddraht verbunden sind. Der Träger wird für den Schnittvorgang durch den Motor entlang einer kreisförmigen Bahn in Richtung der Auflageschiene für den Fotoresistfilm verschwenkt und der Schneiddraht durchtrennt beim Eintreten in den Schlitz der Auflageschiene den auf der Auflageschiene aufliegenden Fotoresistfilm. Bei der vertikalen Positionierung des Schneiddrahts ergibt sich das Problem, daß die vorgewählte Lage des Schneiddrahtes, die beispielsweise mittels einer Positioniervorrichtung festgelegt wird, die tatsächliche Schnittstelle und somit die Abmessungen des zugeschnittenen Fotoresistfilms nur mittelbar anzeigt, da der Schneiddraht keine lineare, sondern eine bogenförmige Bewegung auf den Fotoresistfilm hin ausführt.

Aufgabe der Erfindung ist es, eine Schneidvorrichtung für Fotoresistfilme zu schaffen, die einfach aufgebaut ist, auf kurzen Wegen sowohl in die vorgewählte position gebracht werden kann als auch den Schnitt ausführt und bei der die vorgewählte Position unmittelbar die Schnittstelle auf dem Fotoresistfilm anzeigt.

Diese Aufgabe wird erfindungsgemäß dadurch gelöst, daß, die Schneidvorrichtung durch doppeltwirkende Führungszylinder vor und zurück verschiebbar ist und an Führungen befestigt ist, die entlang vertikaler Führungsstangen durch eine Positioniervorrichtung auf und ab verfahrbar sind, daß auf horizontalen Befestigungsplatten genutete Kugellager um vertikale Kugellagerachsen drehbar gelagert sind, daß der Schneiddraht um die beiden genuteten Kugellager herumgeführt ist und seine Enden mit Federn verbunden sind, die zum Spannen des Schneiddrahts in Stifte auf den Befestigungsplatten eingehängt sind, und daß eine Stromquelle mit den Kugellagern verbunden und in Reihe mit der Stromquelle ein Mikroschalter geschaltet ist, dessen Schaltfahne bei der horizontalen Vorwärtsbewegung der Schneidvorrichtung gegen eine Platte zum Anliegen kommt, dadurch den Mikroschalter betätigt und die Stromquelle abschaltet.

Die weitere vorteilhafte Ausgestaltung der Erfindung ergibt sich aus den Merkmalen der Patentansprüche 2 bis 5.

Mit der Erfindung wird der Vorteil erzielt, daß nur vertikale und horizontale Linearbewegungen von der Schneidvorrichtung ausgeführt werden, die zeitsparend sind und daß bei einer digitalen Vorwahl der Position der Schneidvorrichtung diese entlang der vertikalen Führungsstangen in eine Stellung gebracht wird, die auf der gleichen Höhe wie die Schnittstelle liegt, so daß der unmittelbare Zusammenhang zwischen der vorgewählten Position der Schneidvorrichtung und der Schnittstelle und damit der Abmessung des aufzulaminierenden Fotoresistfilms gegeben ist.

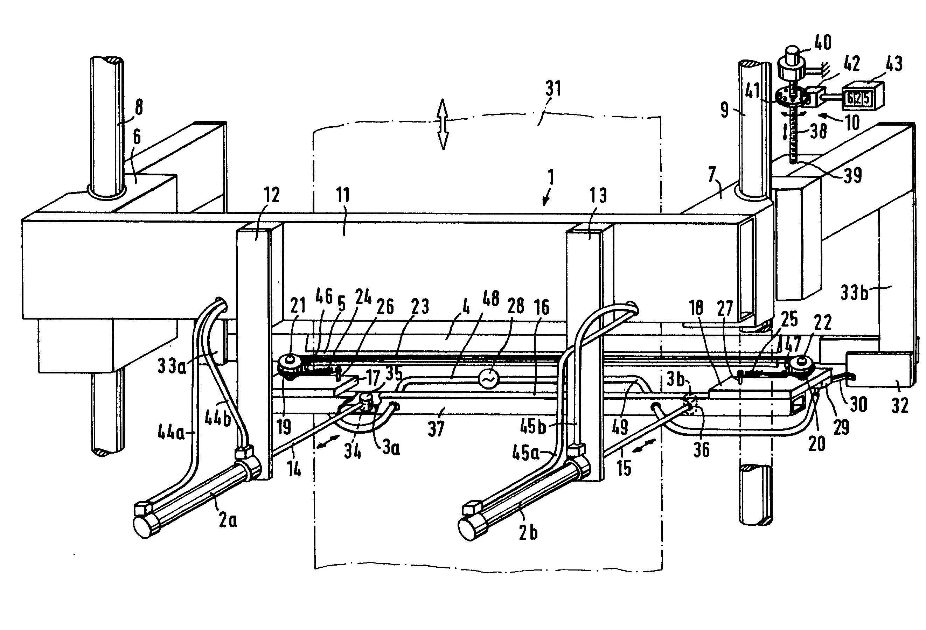

Die Erfindung wird im folgenden anhand der Zeichnung näher erläutert.

Die einzige Figur zeigt eine perspektivische Ansicht einer Schneidvorrichtung 1 mit einem beheizten Schneiddraht 23 für ein zu schneidendes Material 31, beispielsweise einen Fotoresistfilm. Ein Träger in Gestalt eines ersten Vierkantrohres 11 verbindet Führungen 6 und 7 miteinander, die entlang vertikaler Führungsstangen 8 und 9 auf und ab verschiebbar und in einer vorgegebenen Position festlegbar sind. Die Stellung des ersten Vierkantrohres 11 bzw. der Führungen 6 und 7 wird durch eine Positioniervorrichtung 10, die später noch näher beschrieben werden wird, festgelegt. An dem ersten Vierkantrohr 11 sind zwei Vertikalstreben 12 und 13 angebracht, deren unteren Enden etwa auf der Höhe eines weiteren Trägers in Gestalt eines zweiten Vierkantrohres 16 liegen. Auf der Vorderseite jeder Vertikalstrebe 12, 13 ist ein Führungszylinder 2a bzw. 2b befestigt. Bei den Führungszylindern 2a und 2b handelt es sich beispielsweise um doppelt wirkende Pneumatik- oder Hydraulikzylinder, die über Druckleitungen 44a, 44b bzw. 45a, 45b mit dem jeweiligen Betriebsmedium beaufschlagt werden.

Kolbenstangen 14 und 15 der horizontal ausgerichteten Führungszylinder 2a, 2b durchsetzen die Vertikalstreben 12 und 13 und sind mit ihren Enden in Gelenken 3a und 3b gelagert, von denen das Gelenk 3a innerhalb der aufgebrochenen Stelle des zweiten Vierkantrohres 16 dargestellt ist, während das andere Gelenk 3b gestrichelt angedeutet ist. Jedes der Gelenke 3a, 3b besteht aus einem Zylinder, der in das zweite Vierkantrohr 16 eingepaßt ist, wobei seine Grund- und Deckfläche 34 bzw. 35 an der unteren bzw. oberen Innenfläche des Vierkantrohres 16 anliegen. Die Kolbenstangen 14 und 15 besitzen nichtdargestellte Gewinde, die in Gewindebohrungen der Gelenke 3a und 3b eingeschraubt sind. Wie anhand der rechten Kolbenstange 15 zu erkennen ist, durchsetzt sie eine Frontfläche 37 des zweiten Vierkantrohres 16 innerhalb einer kreisförmigen Durchführung 36, die einen Durchmesser besitzt, der geringfügig größer als der Durchmesser der Kolbenstange ist. Das gleiche gilt auch für die linke Kolbenstange 14. Durch das Spiel zwischen den Kolbenstangen 14 und 15 und ihren Durchführungen in der Frontfläche 37 des zweiten Vierkantrohres 16 ist sichergestellt, daß geringfügige Unterschiede der Stellungen der Kolbenstangen 14, 15 beim Ausfahren bzw. beim Zurückziehen ausgeglichen werden können, ohne daß es zu einem Verkanten des zweiten Vierkantrohres 16 während seiner horizontalen Vor- bzw. Rückwärtsbewegung kommt.

Nahe den Enden des zweiten Vierkantrohrs 16 sind auf dessen Deckfläche Befestigungsplatten 17 und 18 horizontal angebracht, von denen jede ein Kugellager 19 bzw. 20 trägt, das um eine vertikale Kugellagerachse 21 bzw. 22 drehbar ist. Der Schneiddraht 23 ist um die beiden genuteten Kugellager 19 und 20 herumgeführt und seine Enden sind mit Federn 24 und 25 verbunden, die zum Spannen des Schneiddrahts 23 in Stifte 26 und 27 auf den Befestigungsplatten 17 und 18 eingehängt sind. Die Heizung des Schneiddrahts 23 erfolgt durch eine Stromquelle 28, die über Kabel 48 und 49 mit einem Schleifkontakt 46, der an dem linken Kugellager 19 anliegt, und mit einem Mikroschalter 29 an der Unterseite der rechten Befestigungsplatte 18 verbunden ist. Die Stromquelle 28 kann eine Wechsel- oder eine Gleichstromquelle sein. Das Kabel 48 verbindet einen Pol der Stromquelle 28 mit dem Schleifkontakt 46. Der zweite Pol der Stromquelle 28 wird über das Kabel 49 an eine Anschlußseite des Mikroschalters 29 geführt. Die andere Anschlußseite des Mikroschalters 29 ist mit dem Schleifkontakt 47 verbunden. Die Schleifkontakte 46 und 47 sind über die Kugellager 19 und 20 mit dem Schneiddraht 23 in Verbindung.

An Rahmenteilen 33a und 33b, die mit den Führungen 6 und 7 in Verbindung stehen, ist eine horizontal verlaufende Schneidleiste 4 mit einer Einkerbung 5 befestigt. Der Schneiddraht 23 und die Einkerbung 5 liegen auf gleicher Höhe. Auf der Vorderseite des rechten Rahmenteils 33b ist eine Platte 32 angeordnet, gegen die eine Schaltfahne 30 des Mikroschalters 29 zum Anliegen kommt, wenn sich die Schneidvorrichtung 1 bzw. der Schneiddraht 23 in Richtung auf die Schneidleiste 4 vorwärtsbewegt. Sowie der Schneiddraht 23 nach dem Durchschneiden des über die Schneidleiste 4 vertikal geführten Materials 31, bei dem es sich bevorzugt um einen Fotoresistfilm handelt, in die Einkerbung 5 der Schneidleiste 4 eintritt, wird die Schaltfahne 30 gegen die Platte 32 gedrückt und der Mikroschalter 29 umgeschaltet, so daß er die elektrische Verbindung der Stromquelle 28 zu dem Schneiddraht 23 unterbricht, so daß dieser stromlos wird. Dadurch wird erreicht, daß es beim horizontalen Zurückziehen des Schneiddrahtes aus der Einkerbung 5 nicht zu einem Festkleben der Schnittkanten des Fotoresistfilms an dem Schneiddraht kommt, der beim Zurückziehen streifend über die Schnittkante geführt wird. Ohne Unterbrechen bzw. Abschalten des Heizstroms für den Schneiddraht 23 wäre dieser beim Zurückziehen in seine Ausgangslage heiß genug, daß es zu einem Ankleben des Fotoresistfilms an beim Passieren der Schnittkante kommen konnte.

Die Positioniervorrichtung 10 für die Schneidvorrichtung 1 stimmt im wesentlichen mit der Positioniervorrichtung überein, die in der Europäischen Patentanmeldung EP-A-0 163 315 vorgeschlagen wird und beteht aus einer Spindel 38, die mit einer Spindelmutter 39 im Eingriff steht, welche an der Rückseite der rechten Führung 7 angeordnet ist. Selbstverständlich kann die Positioniervorrichtung 10 auch an der linken Führung 6 angebracht sein. Auf der Spindel 38 ist eine Loch- oder Schlitzscheibe 41 befestigt, die mit ihrem Rand in eine Lichtschranke 42 hineinragt. Ein Spindelmotor 40 versetzt die Spindel 38, je nachdem ob die Schneidvorrichtung 1 auf oder ab verfahren werden soll, im Uhrzeiger- oder Gegenuhrzeigersinn in Drehung. Während einer ganzen Umdrehung der Spindel bzw. bei jedem vollen Durchgang der Loch- oder Schlitzscheibe 41 durch die Lichtschranke 42 erzeugt diese einen puls, der in einem an die Lichtschranke angeschlossenen Digitalzählwerk 43 angezeigt wird, Die Ganghöhe der Spindel 38 wird beispielsweise so gewählt, daß einer vollen Umdrehung der Spindel 38 eine Vertikalverschiebung der Schneidvorrichtung 1 um einen Millimeter entlang den Führungsstangen 8 und 9 nach oben oder unten entspricht. Die Zahlenangabe des Digitalzählwerks 43 zeigt dann die jeweilige Position der Schneidvorrichtung, d.h. die Entfernung in Millimetern von einer Ausgangs- oder Startposition der Schneidvorrichtung an. Da der Schneiddraht 23 und die Einkerbung 5 der Schneidleiste 4 vor dem Schnitt auf gleicher Höhe liegen, ergibt sich ein unmittelbarer Zusammenhang zwischen der Position der Schneidvorrichtung und dem Zuschnittsformat des Materials 31. Zu Beginn jedes neuen Positioniervorgangs wird die Schneidvorrichtung 1 automatisch in ihre Startposition verfahren, von der aus dann die neu vorgewählte Position angefahren wird.

## Patentansprüche

1. Schneidvorrichtung (1) mit einem beheizten Schneiddraht (23), dessen Halterung auf einem Schlitten montiert ist, der pneumatisch angetrieben ist, wobei die Halterung in eine zur Schlittenbewegung senkrechten Richtung bewegbar ist, dadurch gekennzeichnet, daß die Schneidvorrichtung (1) durch doppeltwirkende Führungszylinder (2a, 2b) vor und zurück verschiebbar ist und an Führungen (6, 7) befestigt ist, die entlang vertikaler Führungsstangen (8, 9) durch eine Positioniervorrichtung (10) auf und ab verfahrbar sind, daß auf horizontalen Befestigungsplatten (17, 18) genutete Kugellager (19, 20) um vertikale Kugellagerachsen (21, 22) drehbar gelagert sind, daß der Schneiddraht (23) um die beiden genuteten Kugellager (19, 20) herumgeführt ist und seine Enden mit Federn (24, 25) verbunden sind, die zum Spannen des Schneiddrahtes (23) in Stifte (26, 27) auf den Befestigungsplatten (17, 18) eingehängt sind, und daß eine Stromquelle (28) mit den Kugellagern (19, 20) verbunden und in Reihe mit der Stromquelle (28) ein Mikroschalter (29) geschaltet ist, dessen Schaltfahne (30) bei der horizontalen Vorwärtsbewegung der Schneidvorrichtung (1) gegen eine platte (32) zum Anliegen kommt, dadurch den Mikroschalter (29) betätigt und die Stromquelle (28) abschaltet.

2. Schneidvorrichtung nach Anspruch 1, dadurch gekennzeichnet, daß ein erstes Vierkantrohr (11) die Führungen (6, 7) miteinander verbindet, daß an dem ersten Vierkantrohr (11) Vertikalstreben (12, 13) angebracht sind, die die doppeltwirkenden Führungszylinder (2a, 2b) tragen, daß Kolbenstangen (14, 15) der Führungszylinder die Vertikalstreben (12, 13) durchsetzen und in Gelenken (3a, 3b) gelagert sind, die in einem unterhalb des ersten Vierkantrohres angeordneten zweiten Vierkantrohr (16) angeordnet sind und daß die horizontalen Befestigungsplatten (17, 18) an den Enden des zweiten Vierkantrohres (16) angebracht sind.

3. Schneidvorrichtung nach den Ansprüchen 1 bis 2, dadurch gekennzeichnet, daß unterhalb des ersten Vierkantrohres (11) eine Schneidleiste (4) mit einer Einkerbung (5) an Rahmenteilen (33a, 33b) befestigt ist, die mit den Führungen (6, 7) verbunden sind und daß der Schneiddraht (23) nach dem Durchschneiden des über die Schneidleiste (4) vertikal geführten Materials (31) in die Einkerbung (5) eintritt und die Schaltfahne (30) des Mikroschalters (29) betätigt wird, um die Verbindung der Stromquelle (28) mit dem Schneiddraht (23) zu unterbrechen.

4. Schneidvorrichtung nach Anspruch 2, dadurch gekennzeichnet, daß jedes der Gelenke (3a, 3b) ein in das zweite Vierkantrohr (16) eingepaßter Zylinder ist, der mit seiner Grund- und Deckfläche (34, 35) an der unteren und oberen Innenfläche des Vierkantrohrs anliegt, daß die Kolbenstangen (14, 15) der Führungszylinder (2a, 2b) mit den Gelenken (3a, 3b) verschraubt sind und daß die kreisförmige Durchführung (36) in der Frontfläche (37) des Vierkantrohres für jede der Kolbenstangen (14, 15) ein Spiel aufweist.

5. Schneidvorrichtung nach Anspruch 1, dadurch gekennzeichnet, daß die Positioniervorrichtung (10) eine Spindel (38) aufweist, die mit einer an der einen Führung (7) befestigten Spindelmutter (39) im Eingriff steht, daß ein Spindelmotor (40) die Spindel (38) in Drehung versetzt, auf der eine Loch- oder Schlitzscheibe (41) aufsitzt, die mit ihrem Rand in eine Lichtschranke (42) hineinragt, die an ein Digitalzählwerk (43) angeschlossen ist.

**Revendications**

1. Dispositif de coupe (1) avec un fil coupant chauffé (23) dont le support est monté sur un coulisseau qui est entraîné pneumatiquement, le support étant mobile dans une direction perpendiculaire au mouvement du coulisseau, caractérisé en ce que le dispositif de coupe (1) peut être déplacé vers l'avant et vers l'arrière par des cylindres de guidage à double action (2a, 2b) et est fixé sur des guides (6, 7) qui peuvent être déplacés vers le haut et vers le bas le long de tiges de guidage verticales (8, 9) par un dispositif de positionnement (10), en ce que des roulements rainurés à billes (19, 20) sont montés rotatifs autour d'axes verticaux de roulements à billes (21, 22) sur des plaques de fixation horizontales (17, 18), en ce que le fil coupant (23) est guidé autour des deux roulements rainurés à billes (19, 20), et ses extrémités sont assemblées à des ressorts (24, 25) qui sont accrochés dans des broches (26, 27) prévues sur les plaques de fixation (17, 18) afin de tendre le fil coupant (23), et en ce qu'une source de courant électrique (28) est reliée aux roulements à billes (19, 20), et un commutateur miniature (29) est monté en série avec la source de courant (28), commutateur dont le talon de commutation (30) vient s'appliquer contre une plaque (32) lors du mouvement horizontal d'avancement du dispositif de coupe (1), actionnant ainsi le commutateur miniature (29) et coupant la source de courant (28).

2. Dispositif de coupe selon la revendication 1, caractérisé en ce qu'un premier tube rectangulaire (11) relie entre eux les guides (6, 7), en ce que des entretoises verticales (12, 13) sont fixées sur le premier tube rectangulaire (11), lesquelles portent les cylindres de guidage à double action (2a, 2b), en ce que des tiges de piston (14, 15) des cylindres de guidage traversent les entretoises verticales (12, 13) et sont montées dans des joints articulés (3a, 3b) qui sont disposés dans un deuxième tube rectangulaire (16) disposé en dessous du premier tube rectangulaire, et en ce que les plaques de fixation horizontales (17, 18) sont fixées aux extrémités du deuxième tube rectangulaire (16).

3. Dispositif de coupe selon la revendication 1 ou 2, caractérisé en ce qu'une barre de coupe (4), munie d'une encocbe (5), est fixée en dessous du premier tube rectangulaire (11) sur des éléments de bâti (33a, 33b) qui sont assemblés aux guides (6, 7), et en ce que le fil coupant (23), après avoir découpé le matériau guidé verticalement au-dessus de la barre de coupe (4), pénètre dans l'encoche (5), et le talon de commutation (30) du commutateur miniature (29) est actionné afin d'interrompre la liaison entre la source de courant (28) et le fil coupant (23).

4. Dispositif de coupe selon la revendication 2, caractérisé en ce que chacun des joints articulés (3a, 3b), est un cylindre inséré dans le deuxième tube rectangulaire (16) et qui s'applique par sa face de dessous et par sa face de dessus (34, 35) contre la face intérieure inférieure et contre la face intérieure supérieure du tube rectangulaire, en ce que les tiges de piston (14, 15) des cylindres de guidage (2a, 2b) sont vissées aux joints articulés (3a, 3b), et en ce que le passage circulaire (36) prévu dans la face frontale (37) du tube rectangulaire pour chacune des tiges de piston (14, 15) présente un jeu.

5. Dispositif de coupe selon la revendication 1, caractérisé en ce que le dispositif de positionnement (10) présente une vis de translation (38) qui coopère avec un écrou (39) fixé sur un guide (7), et en ce qu'un moteur de translation (40) met en rotation la vis de translation (38), sur laquelle repose un disque perforé ou fendu (41) dont le bord pénètre dans une barrière lumineuse (42) qui est reliée à un compteur numérique (43).

**Claims**

1. A cutting device (1) with a heated cutting wire (23) whose mounting is arranged on a pneumatically driven carriage, said mounting being movable in a direction perpendicular to the direction of movement of the carriage, characterized in that said cutting device (1) is displaceable horizontally to an fro by means of double-acting guide cylinders (2a, 2b) and is fastened to guides (6, 7) which are movable up and down along vertical guide rods (8, 9) by means of a positioning device (10), that grooved ball bearings (19, 20) are provided on horizontal fastening plates such that they are capable of rotating about vertical ball-bearing axles, that the cutting wire (23) is guided around the two grooved ball bearings (19, 20) and its ends are connected to springs (24, 25) which are retained in pins (26, 27) provided on the fastening plates (17, 18) in order to tension the cutting wire (23), and that a current source (28) is connected to the ball bearings (19, 20), and a micro switch (29) is connected in series with the current source (28), the switch lug (30) of which switch comes to rest against a plate (32) during the horizontal forward movement of the cutting device (1), thereby actuating the micro switch (29) and switching off the current source (28).

2. The cutting device as claimed in claim 1, characterized in that a first rectangular tube (11) connects the guides (6, 7) to one another, that vertical struts (12, 13), which carry the double-acting guide cylinders (2a, 2b), are attached to said first rectangular tube (11), that piston rods (14, 15) of the guide cylinders pass through the vertical struts (12, 13) and are mounted in joints (3a, 3b) arranged in a second rectangular tube (16) located underneath the first rectangular tube (11), and that the horizontal fastening plates (17, 18) are attached to the ends of the second rectangular tube (16).

3. The cutting device as claimed in claims 1 and 2, characterized in that, underneath the first rectangular tube (11), a cutting bar (4) with a notch (5) is fastened to frame parts (33a, 33b) connected to the guides (6, 7), and that the cutting wire (23), after cutting through the material (31) guided vertically over the cutting bar (4), penetrates into the notch (5), and the switch lug (30) of the micro switch (29) is actuated to break the connection between the current source (28) and the cutting wire (23).

4. The cutting device as claimed in claim 2, characterized in that each of the joints (3a, 3b) is a cylinder which is fitted into the second rectangular tube (16) and which rests by means of its bottom and top surfaces (34, 35) against the lower and upper inner surfaces of the rectangular tube, that the piston rods (14, 15) of the guide cylinders (2a, 2b) are screwed to the joints (3a, 3b), and that the circular duct (36) located in the front surface (37) of the rectangular tube and intended for each of the piston rods (14, 15) has a play.

5. The cutting device as claimed in claim 1, characterized in that the positioning device (10) has a spindle (38) which is engaged with a spindle nut (39) fastened to one guide (7), and that a spindle motor (40) causes the spindle (38) to rotate, there being located on the latter a perforated or slotted disk (41) which projects with its edge into a light barrier (42) connected to a digital counter (43).

1